# EUROPÄISCHE PATENTSCHRIFT

(11) **EP 0 793 407 B1**
(45) Veröffentlichungstag und Bekanntmachung des Hinweises auf die Patenterteilung: **16.04.2003**
(21) Anmeldenummer: 97102088.8
(22) Anmeldetag: 10.02.1997
(51) Int. Cl.: H05K 7/20, H05K 7/00, H05K 5/00

(54) **Elektronische Schalteinrichtung, insbesondere elektronisches Relais, für Steckmontage**
Electronic switching device, particularly electronic relay, for plug-in mounting
Installation électronique de distribution, particulièrement relais électronique, pour montage enfichage

(30) Priorität: 23.02.1996 DE 19606885
(43) Veröffentlichungstag der Anmeldung: 03.09.1997
(73) Patentinhaber: TYCO Electronics Logistics AG, 9323 Steinach (CH)
(72) Erfinder: Samray, Bican, 16321 Schönow (DE); Villain, Jürgen, Dr., 14199 Berlin (DE); Schlaak, Helmut, Dr., 13503 Berlin (DE)
(74) Vertreter: Klunker . Schmitt-Nilson . Hirsch

(56) Entgegenhaltungen:
- EP-A- 0 516 149
- DE-A- 3 035 749
- DE-A- 3 716 196
- DE-A- 4 121 545

## Beschreibung

Die Erfindung betrifft eine elektronische Schalteinrichtung, insbesondere ein elektronisches Relais, mit einer Schaltungsplatine, welche auf einer ersten Oberfläche eine elektronische Schaltungsanordnung und auf der gegenüberliegenden zweiten Oberfläche vorspringende Kühlelemente trägt.

Bei elektronischen Schaltungen mit Leistungshalbleitern ist es wichtig, daß die entstehende Wärme effektiv von der Schaltungsplatine weg und gegebenenfalls aus einem Gehäuse heraus abgeführt wird. In der DE 37 16 196 C2 ist beispielsweise eine Anordnung beschrieben, bei der ein Keramiksubstrat auf seiner einen Oberfläche elektronische Bauelemente trägt, während es mit seiner anderen Oberfläche in wärmeleitender Weise durch eine Klebeschicht mit einer weiteren Keramikplatte verbunden ist, die ihrerseits metallische, wärmeleitende Stifte als Kühlelemente trägt. Dadurch ist eine gute Wärmeableitung von der Schaltungsplatine möglich; doch ist die dort beschriebene Anordnung für sich nicht ohne weiteres handhabbar, insbesondere auch nicht in einer rauhen Umgebung einsetzbar, da die Schaltungsanordnung nicht in einem geschlossenen Gehäuse geschützt ist. Für bestimmte Anwendungen, beispielsweise für ein elektronisches Relais zur Anwendung in einem Kraftfahrzeug, müßte also die dort beschriebene Anordnung erst in ein Gehäuse eingebracht werden, wobei sichergestellt werden müßte, daß die Wärme auch aus dem Gehäuse abgeführt werden kann.

Ziel der vorliegenden Erfindung ist es, eine elektronische Schalteinrichtung zu schaffen, bei der die entstehende Wärme unmittelbar und möglichst wirkungsvoll von der Schaltungsplatine abgeführt wird, wobei aber zugleich die Schaltungsanordnung selbst möglichst gut in einem Gehäuse geschützt ist und wobei die gesamte elektronische Schalteinrichtung als einzelnes Bauelement steckbar ausgeführt ist, so daß sie beispielsweise in einer Relaisbox in einem Kraftfahrzeug mit einem Handgriff eingesteckt bzw. ausgetauscht werden kann.

Erfindugnsgemäß wird dieses Ziel mit einer elektronischen Schalteinrichtung der eingangs genannten Art dadurch erreicht, daß ein flacher Sockel aus Isolierstoff vorgesehen ist, auf dessen Oberseite Anschlußleiter in Form von Blechstreifen befestigt sind, von denen jeweils ein Endabschnitt durch den Sockel zu dessen Unterseite austritt und einen Flachstecker bildet, daß die Schaltungsplatine auf dem Sockel senkrecht zu dessen Hauptebene stehend angeordnet ist und den Raum oberhalb des Sockels in einen die elektronische Schaltungsanordnung einschließenden Schaltungsraum und einen die Kühlelemente enthaltenden Kühlraum unterteilt, daß Anschlußkontakte der Schaltungsanordnung in der Nähe der Sockeloberfläche mit jeweils zugehörigen Anschlußleitern verbunden sind und daß der Schaltungsraum mit einer Abdeckung verschlossen ist, welche die Kühlelemente unbedeckt läßt.

Die erfindungsgemäße Schalteinrichtung ist also auf einem Sockel mit üblichen Flachsteckanschlüssen aufgebaut, wobei die Flachstecker durch Blechstreifen bzw. Stanzgitterteile gebildet sind, die auf der Oberseite des Sockels verlaufen und einzeln mit den Ausgängen der elektronischen Schaltung verbunden sind. Die Schaltungsplatine ihrerseits steht senkrecht auf dem Sockel und bildet so eine Seitenwand eines Gehäuses, welches mit einer zusätzlichen Abdeckung die Schaltungsanordnung umschließt und schützt, zugleich aber, da die Schaltungsplatine selbst eine Außenwand dieses geschlossenen Gehäuses bildet, die von der Rückseite der Schaltungsplatine abgehenden Kühlelemente außerhalb des Gehäuses läßt. Der dadurch gebildete Kühlraum liegt zwar auch über dem Sockel, ist aber zur Außenatmosphäre offen. Die Schaltungsplatine kann beispielsweise von einem Keramiksubstrat gebildet werden, das eine Hybridschaltung trägt und mit seiner gegenüberliegenden Oberfläche wärmeleitend mit einem Kühlkörper verbunden ist, beispielsweise einer Aluminiumplatte mit Kühlrippen. Der Verbund aus Kühlkörper und Schaltungsplatine ist wiederum fest mit dem Sockel verbunden, beispielsweise durch Einstecken in Führungsnuten und Verrasten an entsprechenden Halteelementen. Die elektronischen Bauelemente lassen sich beispielsweise als SMT-Bauelemente oder auch als nackte Chips in Draht-Bond-Technik auf der Platine montieren und besitzen so einen guten Wärmekontakt. So wird die Wärme direkt über die Platine und den Kühlkörper abgeleitet. Die Leiterbahnen bzw. Kontaktflächen des Keramiksubstrats werden vorzugsweise über eine in einer Ebene liegende Anschlußreihe durch Bonden kontaktiert. Zum Schutz gegen mechanische Belastung und Umwelteinflüsse wird vorzugsweise der Schaltungsraum mit einer Vergußmasse, vorzugsweise einem weichen Kunststoff, wie Silikon, ausgegossen. Auf diese Weise ergibt sich eine kostengünstige Montage.

In einer anderen vorteilhaften Ausgestaltung können die Funktionen der Schaltungsplatine und des Kühlkörpers auch von einem einzigen Teil übernommen werden. Zu diesem Zweck wird vorzugsweise eine Aluminium-Leiterplatte mit einer Eloxal-Isolationsschicht und Leiterbahnen in partieller Eloxal-Metallisierung verwendet. Derartige Leiterplatten sind beispielsweise in der DE 30 35 749 A1 beschrieben.

Die Erfindung wird nachfolgend an Ausführungsbeispielen anhand der Zeichnung näher erläutert. Es zeigt
Figur 1 ein erfindungsgemäß gestaltetes elektronisches Relais mit teilweise aufgebrochenem Gehäuse,
Figur 2 eine Schaltungsplatine mit Kühlelementen bei der Montage auf einem Sockel für ein Relais gemäß Figur 1,
Figur 3 ein etwas abgewandeltes elektronisches Relais mit abgehobener Gehäusekappe,
Figur 4 eine rückseitige Ansicht auf den Sockel (ohne Flachstecker dargestellt) und die mit Kühlelementen versehene Schaltungsplatine bei der Montage,
Figur 5a einen schematisierten Teilschnitt A-A durch die Anordnung von Figur 4 (bei fertig eingesteckter Schaltungsplatine) und
Figur 5b einen schematisierten Teilschnitt B-B aus Figur 4 (ebenfalls nach dem Einstecken der Schaltungsplatine).

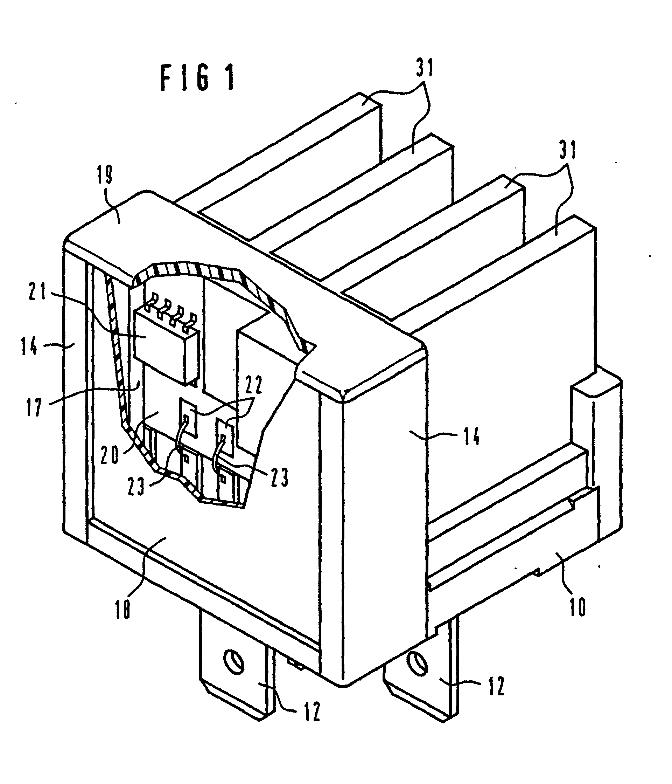

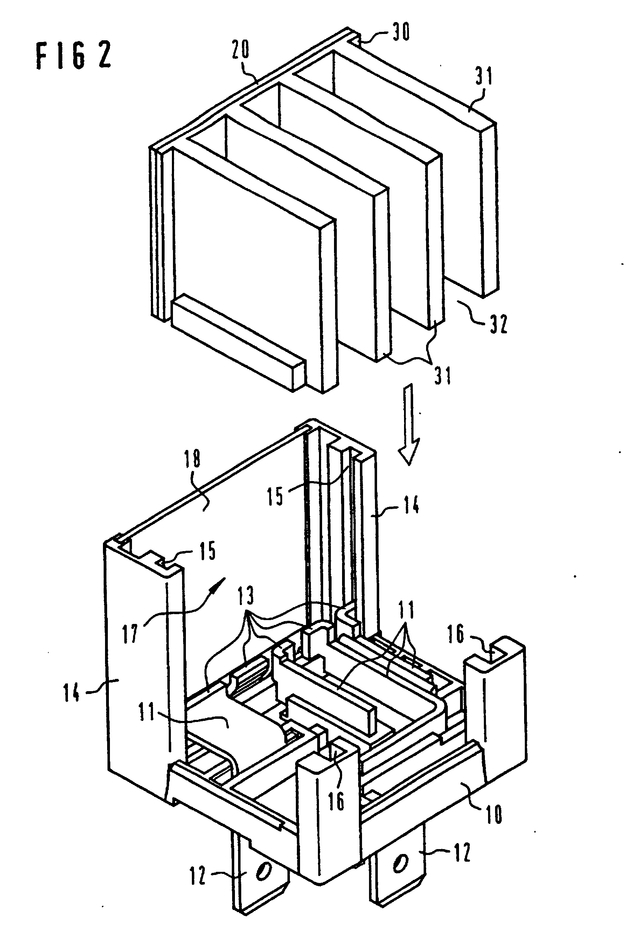

Das in den Figuren 1 und 2 dargestellte elektronische Relais besitzt einen Sockel 10 aus Isolierstoff, auf welchem eine Schaltungsplatine 20 senkrecht stehend aufgesetzt wird. Die Schaltungsplatine 20 ist fest und wärmeleitend, beispielsweise durch Kleben, mit einer Kühlplatte 30 verbunden, welche ihrerseits senkrecht abstehende Kühlrippen 31 trägt.

Auf der Sockeloberseite sind Anschlußleiter 11 angeordnet und verankert. Sie sind aus Blech gestanzt und gebogen und bilden jeweils senkrecht durch die Sockelebene zur Unterseite herausgeführte Flachstecker 12, während ihre entgegengesetzten Enden jeweils zu Kontaktierungsabschnitten 13 gebogen sind. Die Anschlußleiter können auch teilweise in den Sockel 10 eingebettet sein. Diese Kontaktierungsabschnitte 13 liegen alle nebeneinander in einer gemeinsamen Ebene unterhalb der Schaltungsplatine 20. Die mit elektronischen Bauelementen 21 bestückte Schaltungsplatine 20 besitzt nicht näher dargestellte Leiterbahnen, die unter anderem mit Kontaktflächen 22 an dem unteren, dem Sockel zugewandten Ende der Schaltungsplatine 20 verbunden sind. Die Kontaktflächen 22 sind, wie in Figur 1 gezeigt, durch Bonddrähte 23 mit den Kontaktierungsabschnitten 13 der Anschlußleiter elektrisch verbunden. Auf diese Weise sind die elektrischen Verbindungen zwischen der elektronischen Schaltung und den Flachsteckern 12 hergestellt.

Zur Halterung der Verbundplatte aus der Schaltungsplatine 20 und der Kühlplatte 30 besitzt der Sockel beiderseits Haltesäulen 14 mit senkrechten Führungsnuten 15, in die die genannte Doppelplatte 20,30 eingeschoben wird. Zur Führung der äußeren Kühlrippen 31 sind weitere Haltenuten 16 an den anderen Enden des Sockels vorgesehen. Vorzugsweise wird die Kühlplatte 30 mit der Schaltungsplatine 20 nach dem Einschieben zusätzlich verrastet oder verriegelt bzw. verklebt, um die Kontaktierung mit den Anschlußleitern zu ermöglichen und eine Belastung der Bonddrähte durch Relativbewegung der Schaltungsplatine zu vermeiden. Nach der Bestückung und Kontaktierung kann der durch die Schaltungsplatine 20 und die Haltesäulen 14 gebildete Schaltungsraum 17 an der offenen Seite durch eine Abdeckplatte 18 und an der Oberseite durch einen Deckel 19 verschlossen werden. Die Abdeckplatte 18 und der Deckel 19 können natürlich auch aus einem Stück bestehen. Außerdem kann der Schaltungsraum 17 mit Vergußmasse ausgefüllt werden, beispielsweise mit einem weichen Silikon. Damit wird die elektronische Schaltung zusätzlich gegen mechanische Belastung und gegen Umwelteinflüsse geschützt. Durch das Vergießen kann auch die Sockeloberseite im Bereich zwischen den Kühlplatten 31 abgedeckt werden, wodurch die Anschlußleiter geschützt und isoliert werden.

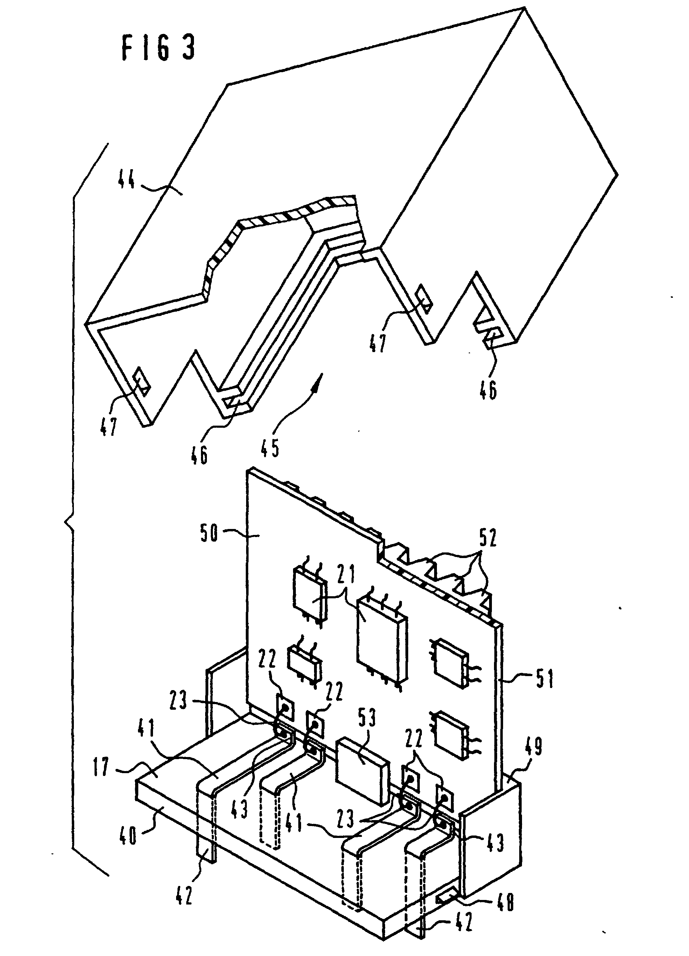

In Figur 3 ist eine etwas abgewandelte Ausführungsform gezeigt. Ein Sockel 40 ist mit Anschlußleitern 41 wie im vorhergehenden Fall versehen, welche nach unten Flachstecker 42 bilden und an den entgegengesetzten Enden mit nach oben gebogenen, in einer Ebene liegenden Kontaktierungsabschnitten 43 versehen sind.

Eine Schaltungsplatine 50 ist wie im vorhergehenden Beispiel mit elektronischen Bauelementen 21 bestückt. Außerdem trägt sie nicht weiter gezeigte Leiterbahnen und Kontaktierungsflächen 22, die mit Bonddrähten 23 mit den Kontaktierungsabschnitten 43 der Anschlußleiter verbunden sind.

Die Schaltungsplatine 50 besteht in diesem Fall aus einer Aluminium-Leiterplatte mit Eloxal-Isolationsschicht und mit Leiterbahnen in partieller Eloxal-Metallisierung. Sie könnte aber auch konventionell eine Hybridkeramik oder Leiterplatte mit rückseitig ganzflächig angebrachtem, hier jedoch flachem Kühlkörper sein. Wie im vorherigen Beispiel dient die Platine 50 als Wandelement des Schaltungsraums 17, der mit einer aufgesetzten Kappe 44 abgeschlossen werden kann. Diese Kappe 44 besitzt eine offene Wandseite 45, die beim Aufstecken durch die Schaltungsplatine 50 verschlossen wird. Zu diesem Zweck ist diese offene Wandseite 45 mit einer umlaufenden Nut 46 versehen, in die ein Wandsteg 51 der Schaltungsplatine eingreift. Mit Ausnehmungen 47 kann die Kappe 44 an Rastnasen 48 des Sockels verrastet werden.

Die Schaltungsplatine 50 ist, abgesehen von dem erwähnten Randsteg 51, an der den Bauelementen 21 gegenüberliegenden Seite mit Kühlrippen 52 versehen. Über sie wird die Wärme von den Leistungsbauelementen unmittelbar nach außen abgeführt. Der durch die Kappe 44 abgeschlossene Schaltungsraum 17 kann auch in diesem Fall durch Füllen mit Vergußmasse zusätzlich mechanisch stabilisiert und gegen Umwelteinflüsse geschützt werden.

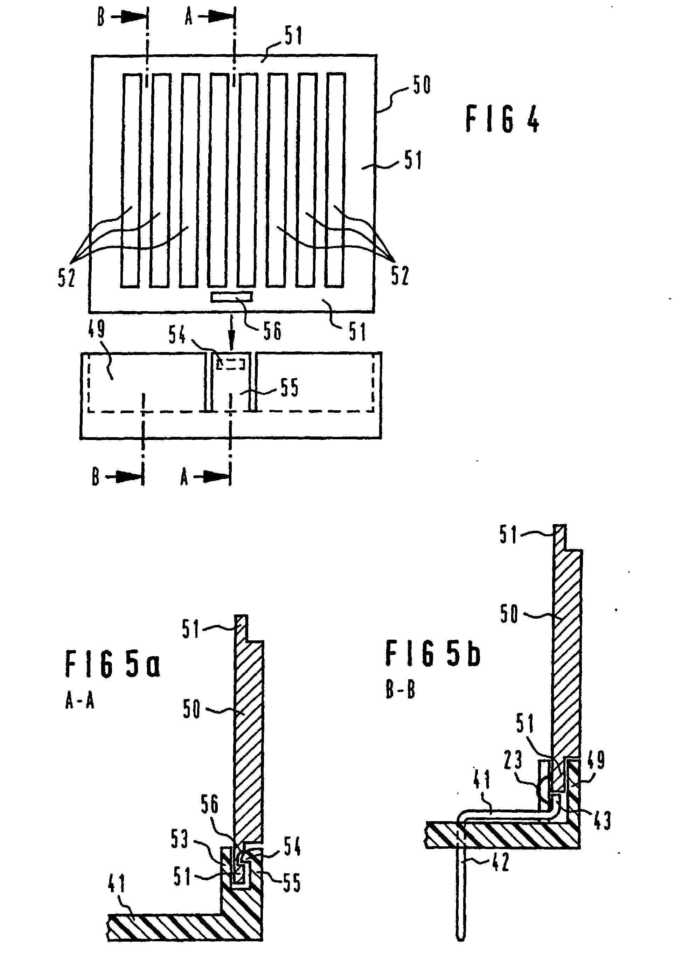

Bei der Montage muß die Schaltungsplatine 50 auch in diesem Fall am Sockel fixiert werden, um die Kontaktierung über die Bonddrähte 23 zu ermöglichen und frei von Kräften zu halten. Diese Fixierung ist schematisch in den Figuren 4, 5A und 5B gezeigt. Zum Zweck dieser Fixierung besitzt der Sockel einen nach oben gezogenen Haltesteg 49 sowie im Mittelbereich parallel dazu eine Stützplatte 53. Die Schaltungsplatine 50 wird bei der Montage mit ihrem unteren Randsteg 51 zwischen dem Haltesteg 49 und der Stützplatte 53 eingesteckt und eingeklemmt. Dabei rastet eine Rastnase 54 an einer Haltezunge 55 in eine Vertiefung 56 der Schaltungsplatine ein. Diese Fixierung ist erforderlich, um die elektrischen Verbindungen von der Platine auf die Anschlußleiter 41 durch Bonddrähte zu gewährleisten. Dabei sind die bondbaren Enden der Anschlußabschnitte 43 wie im vorhergehenden Beispiel so angeordnet, daß sie mit der Bestückungsseite der Schaltungsplatine 50 eine Ebene bilden.

## Patentansprüche

1. Elektronische Schalteinrichtung, insbesondere elektronisches Relais, mit einer Schaltungsplatine (20;50), welche auf einer ersten Oberfläche eine elektronische Schaltungsanordnung (21) und auf der gegenüberliegenden zweiten Oberfläche vorspringende Kühlelemente (31;52) trägt,
**dadurch gekennzeichnet, daß** ein flacher Sockel (10;40) aus Isolierstoff vorgesehen ist, auf dessen Oberseite Anschlußleiter (11;41) in Form von Blechstreifen befestigt sind, von denen jeweils ein Endabschnitt durch den Sockel zu dessen Unterseite austritt und einen Flachstekker (12;42) bildet, **daß** die Schaltungsplatine (20;50) auf dem Sockel (10;40) senkrecht zu dessen Hauptebene stehend angeordnet ist und den Raum oberhalb des Sockels in einen die elektrische Schaltungsanordnung einschließenden Schaltungsraum (17) und einen die Kühlelemente enthaltenden Kühlraum (32) unterteilt, **daß** Anschlußkontakte (22) der Schaltungsanordnung in der Nähe der Sockeloberfläche mit jeweils zugehörigen Anschlußleitern (11;41) verbunden sind und **daß** der Schaltungsraum (17) mit einer Abdeckung (18,19;44) verschlossen ist, welche die Kühlelemente (31;52) unbedeckt läßt.

2. Schalteinrichtung nach Anspruch 1,
**dadurch gekennzeichnet, daß** die Anschlußleiter (11;41) jeweils Kontaktierungsabschnitte (13;43) aufweisen, die unterhalb der Schaltungsplatine (2;50) annähernd in deren Ebene liegen und mit entsprechenden Leiterbahnen verbunden sind.

3. Schalteinrichtung nach Anspruch 2,
**dadurch gekennzeichnet, daß** die Leiterbahnen der Schaltungsplatine Kontaktflächen (22) aufweisen, die annähernd in der gleichen Ebene wie die zugehörigen Kontaktierungsabschnitte (13;43) der Anschlußleiter liegen und mit diesen durch Bonddrähte (23) verbunden sind.

4. Schalteinrichtung nach einem der Ansprüche 1 bis 3,
**dadurch gekennzeichnet, daß** an dem Sockel (10;40) jeweils Führungs- und/oder Halteelemente (14,15,16;49,53,54,56) für die Schaltungsplatine (20;50) vorgesehen sind.

5. Schalteinrichtung nach einem der Ansprüche 1 bis 4,
**dadurch gekennzeichnet, daß** die Kühlelemente (31) Teil einer Kühlplatte (30) sind, die der Schaltungsanordnung gegenüberliegend mit der Schaltungsplatine (20) verbunden ist.

6. Schalteinrichtung nach Anspruch 5,
**dadurch gekennzeichnet, daß** die Schaltungsplatine (20) aus einem Keramiksubstrat besteht.

7. Schalteinrichtung nach einem der Ansprüche 1 bis 6,
**dadurch gekennzeichnet, daß** die Kühlelemente an einer Kühlplatte aus Aluminium (30) angeformt sind.

8. Schalteinrichtung nach einem der Ansprüche 1 bis 4,
**dadurch gekennzeichnet, daß** die Kühlelemente (52) Teil einer partiell mit Isolations- und Leiterschichten versehenen Metallplatte sind, die zugleich als Schaltungsplatine (50) dient.

9. Schalteinrichtung nach einem der Ansprüche 1 bis 8,
**dadurch gekennzeichnet, daß** der Schaltungsraum (17) mit Kunststoff ausgegossen ist.

## Claims

1. An electronic switching device, in particular an electronic relay, having a circuit board (20; 50) which carries an electronic circuit arrangement (21) on a first surface and projecting cooling elements (31; 52) on the opposed second surface,
**characterised in that** a flat base (10; 40) made of insulating material is provided, to the upper side whereof terminal conductors (11; 41) in the form of metal strips are secured, of which in each case an end portion emerges through the base on the underside thereof and forms a flat connector (12; 42), **in that** the circuit board (20; 50) is arranged upright on the base (10; 40) and perpendicular to the main plane thereof and divides the space above the base into a circuit space (17) enclosing the electrical circuit arrangement and a cooling space (32) containing the cooling elements, **in that** terminal contacts (22) of the circuit arrangement are connected to respectively associated terminal conductors (11; 41) in the vicinity of the base surface, and **in that** the circuit space (17) is closed by a cover (18, 19; 44) which leaves the cooling elements (31; 52) uncovered.

2. A switching device according to Claim 1, **characterised in that** the terminal conductors (11; 41) each have contact-making portions (13; 43) which lie below the circuit board (2; 50) and approximately in the plane thereof and are connected to corresponding conductor traces.

3. A switching device according to Claim 2, **characterised in that** the conductor traces of the circuit board have contact faces (22) which lie approximately in the same plane as the associated contact-making portions (13; 43) of the terminal conductors and are connected thereto by bonding wires (23).

4. A switching device according to one of Claims 1 to 3, **characterised in that** respective guiding and/or holding elements (14, 15, 16; 49, 53, 54, 56) for the circuit board (20; 50) are provided on the base (10; 40).

5. A switching device according to one of Claims 1 to 4, **characterised in that** the cooling elements (31) are part of a cooling panel (30) which is connected to the circuit board (20) opposite the circuit arrangement.

6. A switching device according to Claim 5, **characterised in that** the circuit board (20) is made of a ceramic substrate.

7. A switching device according to one of Claims 1 to 6, **characterised in that** the cooling elements are integrally formed on a cooling panel made of aluminium (30).

8. A switching device according to one of Claims 1 to 4, **characterised in that** the cooling elements (52) are part of a metal panel which is provided in certain parts with insulating and conductor layers and at the same time serves as a circuit board (50).

9. A switching device according to one of Claims 1 to 8, **characterised in that** the circuit space (17) is filled up with cast synthetic material.

## Revendications

1. Dispositif électronique de commutation, en particulier relais électronique, comportant une platine de commutation (20; 50) comportant sur une première surface un dispositif de commutation électronique (21) et sur la deuxième surface opposée des éléments de refroidissement en saillie (31; 52),
**caractérisé en ce qu'**un socle plat (10; 40) composé d'un matériau isolant est prévu, sur le côté supérieur duquel sont fixés des conducteurs de connexion (11; 41) sous forme de bandes de tôle, dont une section d'extrémité respective déborde à travers le socle vers le côté inférieur correspondant et constitue une fiche plate (12; 42), la platine de commutation (20; 50) étant agencé debout sur le socle (12; 42) de manière perpendiculaire par rapport à son plan principal, et subdivisant l'espace au-dessus du socle en un espace de commutation (17) renfermant le dispositif de commutation électronique et un espace de refroidissement (32) contenant les éléments de refroidissement, des contacts de raccordement (22) du dispositif de commutation étant reliés à proximité de la surface du socle avec des conducteurs de raccordement correspondants (11; 41) et l'espace de commutation (17) étant fermé par une couverture (18, 19; 44), ne recouvrant pas les éléments de refroidissement (31; 52).

2. Dispositif de commutation selon la revendication 1, **caractérisé en ce que** les conducteurs de raccordement (11; 41) comportent respectivement des sections d'établissement de contact (13; 43) agencées au-dessous de la platine de commutation (2; 50), pratiquement dans le plan de celle-ci et étant raccordées à des pistes conductrices correspondantes.

3. Dispositif de commutation selon la revendication 2, **caractérisé en ce que** les pistes conductrices de la platine de commutation comportent des surfaces de contact (22) situées pratiquement dans le même plan que les sections d'établissement de contact correspondantes (13; 43) des conducteurs de raccordement et reliées à celles-ci par des fils de liaison (23).

4. Dispositif de commutation selon l'une des revendications 1 à 3, **caractérisé en ce que** le socle (10; 40) comporte respectivement des éléments de guidage et/ou de retenue (14, 15, 16; 49, 53, 54, 56) pour la platine de commutation (20; 50).

5. Dispositif de commutation selon l'une des revendications 1 à 4, **caractérisé en ce que** les éléments de refroidissement (31) font partie d'une plaque de refroidissement (30), reliée à la platine de commutation (20) en un point opposé au dispositif de commutation.

6. Dispositif de commutation selon la revendication 5, **caractérisé en ce que** la platine de commutation (20) est composée d'un substrat céramique.

7. Dispositif de commutation selon l'une des revendications 1 à 6, **caractérisé en ce que** les éléments de refroidissement sont agencés sur une plaque de refroidissement composée d'aluminium (30).

8. Dispositif de commutation selon l'une des revendications 1 à 4, **caractérisé en ce que** les éléments de refroidissement (52) font partie d'une plaque métallique pourvue en partie de couches isolantes et conductrices, servant en même temps de platine de commutation (50).

9. Dispositif de commutation selon l'une des revendications 1 à 8, **caractérisé en ce que** l'espace de commutation (17) est garni de matière plastique.
